Europäisches Patentamt

European Patent Office

Office européen des brevets

(19)

(11) Numéro de publication: **0 172 489 B1**

## FASCICULE DE BREVET EUROPEEN

(12)

(45) Date de publication de fascicule du brevet:
13.03.91

(51) Int. Cl.⁵: **G11B 7/26**, C23C 14/14,
C23C 14/34, C23C 14/35

(21) Numéro de dépôt: 85109866.5

(22) Date de dépôt: 06.08.85

(54) **Couche métallique pour support d'information inscriptible thermo-optiquement et son procédé de fabrication.**

(30) Priorité: 09.08.84 FR 8412602

(43) Date de publication de la demande:
26.02.86 Bulletin 86/09

(45) Mention de la délivrance du brevet:
13.03.91 Bulletin 91/11

(84) Etats contractants désignés:
DE GB IT NL SE

(56) Documents cités:
EP-A- 0 083 396
EP-A- 0 090 461
GB-A- 2 102 027

PATENTS ABSTRACTS OF JAPAN, vol. 3, no.
143 (E-154), 27 novembre 1979, page 44 E
154; & JP - A - 54 121 154 (SHARP K.K.)
20-09-1979

METAL FINISHING, juillet 1976, pages 46-51,
Hackensack, US; J.A. THORNTON et al.:
"Sputter deposition onto plastics"

METAL FINISHING, août 1976, pages 32-40,

Hackensack, US; J.A. THORNTON: "Sputter
deposition onto plastics"

"Handbook of Thin Film Technology" by
Leon I.Maissel et Reinhard
Glang,1970,Mc-Graw-Hill Book company,pages 4-8,4-9,et 4-18

(73) Titulaire: THOMSON S.A.
173, bld Haussmann
F-75008 Paris(FR)

(72) Inventeur: Benhamou, Alain
152, rue E. Dolet
F-94140 Alfortville(FR)

(74) Mandataire: Grynwald, Albert et al
THOMSON-CSF SCPI
F-92045 PARIS LA DEFENSE CEDEX 67(FR)

## Description

La présente invention se rapporte à l'enregistrement par voie thermo-optique de l'information. Cette technique d'enregistrement est basée sur la mise en oeuvre d'une structure thermosensible possédant une surface de référence dans l'étendue de laquelle sont produites des modifications localisées de ses caractéristiques optiques. Ces modifications sont lisibles optiquement et sont le résultat de l'interaction produite par un faisceau laser focalisé qui explore la surface de référence et dont l'intensité est modulée en accord avec l'information à transcrire.

La technique d'enregistrement thermo-optique offre l'avantage de ne nécessiter aucun traitement postérieur à l'insolation de la surface photosensible, si bien que la structure thermosensible peut être protégée dès sa fabrication par une enveloppe perméable aux rayonnements d'écriture et de lecture.

En outre, le fait que la lecture peut intervenir immédiatement après l'inscription des données rend aisée l'exploitation d'un tel support d'information comme mémoire de masse à haute densité d'information.

L'enregistrement thermo-optique est fondé sur la conversion en chaleur d'une fraction aussi importante que possible de l'énergie rayonnée incidente.

Cela suppose que l'un des éléments de la structure thermosensible est capable, sous une très faible épaisseur, d'absorber le rayonnement incident. La chaleur dégagée par l'impact du faisceau optique est destinée à produire la modification de caractéristique optique désirée en jouant sur l'élévation de température associée au dégagement de chaleur. Pour des raisons d'efficacité et de résolution, l'échauffement transitoire doit rester confiné à proximité immédiate du centre de la zone d'impact du faisceau inscripteur. L'élévation de température au centre, lorsqu'elle atteint une valeur de seuil prédéterminée initie la phase proprement thermique du processus d'écriture qui peut mettre en oeuvre un phénomène d'ablation, de coalescence, de déformation ou de changement de texture. Ainsi il devient possible de différencier optiquement les zones de la structure thermosensible où le phénomène thermique s'est développé de celles qui ont conservé leur aspect initial.

La présente invention vise plus particulièrement le dépôt d'un film métallique continu de quelques dizaines à quelques centaines d'angströms d'épaisseur, couche qui constitue dans une structure thermosensible l'élément collecteur du rayonnement incident où siège l'émission de chaleur ; celui-ci pouvant être changé dans sa forme ou sa texture du fait de son propre échauffement transitoire et/ou de l'échauffement qu'il communique à un élément sous-jacent avec lequel il coopère. Typiquement, le film métallique optiquement absorbant peut appartenir à une structure thermosensible comportant la formation d'irrégularités de surface telles que cratères ou bulles, mais aussi à des structures conservant un aspect pratiquement lisse, mais où la lisibilité optique découle d'un changement de texture décelable optiquement.

La demande de brevet FR-A-2474222 en France déposée le 23 Janvier 1980 sous le le numéro 80/01432 au nom de THOMSON-CSF avec l'intitulé "PROCEDE D'INSCRIPTION THERMO-OPTIQUE D'INFORMATION ET SUPPORT D'INFORMATION DESTINE A LA MISE EN OEUVRE DE CE PROCEDE" a décrit un processus d'écriture thermo-optique qui consiste à provoquer entre une couche métallique optiquement absorbante et une sous couche organique à diffusivité thermique faible une perte d'adhérence localisée au point d'impact d'un faisceau inscripteur. Cette perte d'adhérence est associée à un dégagement gazeux qui, par expansion, produit une déformation sans rupture de la couche métallique. La demande de brevet en France FR-A-2368779 déposée le 22 octobre 1976 sous le numéro 7631867 au nom de Thomson Brandt avec l'intitulé "SUPPORT D'INFORMATION DESTINE A L'ENREGISTREMENT D'INFORMATION ET PROCEDE D'ENREGISTREMENT D'INFORMATION SUR UN TEL SUPPORT" avait décrit une structure à double couche similaire, mais où le dégagement gazeux pouvait provoquer la rupture de la couche métallique. Ces deux documents suggèrent de réaliser le dépôt de la couche métallique par effet Joule, c'est à dire par évaporation sous vide poussé de métaux tels que l'or et le chrome. Le brevet américain 4,414,273 suggère de réaliser un support d'information thermosensible comprenant une couche thermosensible métallique. Il suggère un grand nombre de métaux pouvant être combinés parmi lesquels figurent l'or et le chrome et il fait référence à plusieurs techniques de dépôt sous des épaisseurs de l'ordre de 300 à $1500 \times 10^{-10}$ m (300 à 1500 Angströms). La pulvérisation et le dépôt en phase vapeur sont mentionnés dans ce document.

L'insolation thermo-optique d'un support d'information ayant pour objet d'utiliser l'impact d'un faisceau de rayonnement pour l'adressage d'une zone thermosensible, il faut encore que le changement de forme ou de texture produise une trace durable dans la surface de référence explorée par le faisceau et que cette trace soit aussi nette et ténue que possible . Le rôle de la couche métallique est donc d'absorber le rayonnement, de s'opposer à l'étalement en surface de la chaleur et lorsque le changement de forme ou de texture s'est manifesté, de participer au développement d'une empreinte assurant une lecture précise à court terme, mais aussi à long terme.

Sachant que l'épaisseur d'une couche métallique mince intervient pour fixer ses propriétés absorbantes et sa diffusivité thermique, il est important de déterminer la composition et la technique de dépôt qui offre la meilleure latitude d'exposition, sans perdre de vue la sensibilité exigée, le rendement de fabrication et la stabilité à long terme de la structure thermosensible. Pratiquement, on s'efforce d'obtenir pour des épaisseurs allant jusqu'à $300 \times 10^{-10}$ m (300 Angströms) un pouvoir absorbant élevé associé à une faible diffusivité thermique. La mesure de la diffusivité thermique étant délicate, on peut la déduire d'autres grandeurs physiques qui sont la masse spécifique et la conductivité thermique. Pour caractériser un dépôt métallique en matière de conductivité thermique, on peut s'appuyer qualitativement sur la connaissance de la conductivité électrique, car ces deux grandeurs sont corrélées et la seconde est plus facile à mesurer.

La technique de l'évaporation sous vide d'une composition à base de métal précieux et d'un adjuvant métallique pour former un film métallique à la surface d'un matériau organique a été suggérée dans la demande de brevet FR-A-2474222 N° 80/01423 comme constituant un élément de structure approprié pour l'inscription thermo-optique. L'or cité en exemple permet d'obtenir des qualités de résistance à l'oxydation.

L'alliage $Cr_{20} Au_{80}$ (en poids) a permis d'obtenir avec des épaisseurs de 40 à $100 \times 10^{-10}$ m (40 à 100 Angströms), un pouvoir absorbant optique élevé et des qualités de dureté et de ductilité très appréciables pour graver des bulles avec une puissance laser incidente de seulement 8 milliwatt. L'évaporation sous vide présente cependant des inconvénients.

En effet, le creuset où sont chauffés les constituants métalliques est régi par la loi des phases de GIBBS de sorte que la composition du dépôt n'a que peu de rapport avec le contenu du creuset. Un autre inconvénient est lié à la cinétique des particules métalliques à l'approche du support de couche qui fait que les sites occupés par les premières particules accrochées au support ont tendance à capter les particules suivantes, les empêchant de donner naissance à de nombreux points de nucléation.

Il en résulte un dépôt sous la forme d'agrégats cristallins à texture relativement grossière qui conduit en général à une limite élastique relativement faible. En outre, le dépôt par évaporation sous vide tend à favoriser l'existence de régions limitrophes oxydées dont l'épaisseur n'est pas négligeable par rapport à l'épaisseur globale du film déposé.

En vue de pallier ces inconvénients, l'invention prévoit de réaliser sur un support le dépôt d'un film dont les constituants métalliques de départ sont agencés sur une cible. Cette cible, placée en regard du support, fait l'objet d'un bombardement ionique intense capable de conférer aux atomes métalliques extraits de cette cible assez d'énergie pour développer à la surface du support un agregat polycristallin ayant une texture sensiblement plus fine que celle à laquelle donne lieu un dépôt par évaporation sous vide poussé. Ce dépôt par pulvérisation cathodique a lieu sous pression réduite dans une enceinte à vide qui renferme un gaz rare. Des moyens magnétiques de confinement du bombardement de la cible sont prévus pour permettre la collecte d'atomes le plus près possible de la cible et favoriser ainsi la multiplication des sites de nucléation, ce qui limite la croissance des grains.

Une telle technique de dépôt par pulvérisation cathodique a moyen magnétique de confinement est déjà connue par l'ouvrage intitulé "Handbook of thin film technology" Leon I. MAISSEL et Reinhard GLANG, 1970, McGraw Hill Book Company, pages 4-8, 4-9, 4-18, 4-39 et 4-40.

L'invention a pour objet un procédé de fabrication d'un support d'information a inscription thermo-optique du type comportant une structure thermosensible adaptée au stockage et à la lecture optique d'information, ladite structure étant munie d'une couche mince métallique qui en collectant le rayonnement inscripteur incident produit un échauffement transitoire localisé faisant naître au-dessus d'un seuil de température un changement de caractéristique optique de ladite structure thermosensible, ledit procédé comportant à cet effet le dépôt d'un agrégat polycristallin en forme de film mince recouvrant continûment une surface d'accueil de ladite structure, ce dépôt provenant d'un flux incident de particules de métal précieux et d'un métal de transition.

Selon un premier aspect de l'invention ce procédé est caractérisé en ce que les particules métalliques sont extraites d'une de chrome et d'une cible d'or cibles exposées au bombardement d'autres particules confinées par champ magnétique qui proviennent d'une décharge électrique à tension de l'ordre de 200 volts dans de l'argon sous pression réduite de l'ordre de $10^{-3}$ torr (1 torr $= 1,3$ hPa) et en ce que la distance cible-surface d'accueil est de l'ordre de 18 à 20 cm, la surface d'accueil collectant les particules métalliques avec une énergie résiduelle donnant lieu à une densité de sites de nucléation accrue par rapport à celle d'un dépôt similaire par évaporation sous vide.

Ce procédé permet la fabrication d'une couche métallique pour support d'information inscriptible thermo-optiquement qui est caractérisée en ce que ladite couche forme un agrégat polycristallin comprenant 35 % de chrome et le reste d'or dont la taille moyenne des grains est de l'ordre de 70 $70 \times 10^{-10}$ m (Angströms), cette couche étant telle que la diffraction électronique montre des anneaux caractéristiques de la structure cubique à face centrée de l'or à faible élargissement.

Selon un second aspect de l'invention le procédé susmentionné est caractérisé en ce que les particules métalliques sont extraites d'une cible de chrome partiellement masquée par des pastilles d'or, cette cible étant exposée au bombardement d'autres particules confinées par champ magnétique qui proviennent d'une décharge électrique sous tension de l'ordre de 200 volts dans un de l'argon sous pression réduite de l'ordre de $10^{-3}$ torr (1 torr = 1,3hPa), la distance cible-surface d'accueil étant de l'ordre de 8 cm, et la surface d'accueil collectant les particules métalliques avec une énergie résiduelle donnant lieu à une densité de sites de nucléation accrue par rapport à celle d'un dépôt similaire par évaporation sous vide.

Un tel procédé permet de fabriquer une couche qui est caractérisée en ce qu'elle forme une agrégat polycristallin contenant environ 50 à 70 % de chrome le reste étant de l'or, cette couche étant telle que la diffraction électronique présente des anneaux diffus et la taille moyenne des grains n'excédant pas $20 \times 10^{-10}$ m (20 Angströms).

Selon un troisième aspect de l'invention, le procédé indiqué ci-dessus est caractérisé en ce que les particules métalliques sont extraites d'une cible cylindrique constituée de chrome, sa surface exposée au bombardement étant partiellement recouverte par de l'or, cette cible étant exposée au bombardement d'autres particules confinées par champ magnétique dirigé suivant l'axe de la cible cylindrique et qui proviennent d'une décharge électrique d'une tension de l'ordre de 200 volts dans un gaz rare sous pression réduite de l'ordre de $10^{-3}$ torr (1 torr = 1,3hPa), la surface d'accueil, disposée parallèlement à l'axe de la cible, étant à une distance de cette dernière de l'ordre de 10 cm et collectant les particules métalliques avec une énergie résiduelle donnant lieu à une densité de sites de nucléation accrue par rapport à celle d'un dépôt similaire par évaporation sous vide.

L'invention a également pour objet le support d'information obtenu par le procédé sus-mentionné.

L'invention sera mieux comprise au moyen de la description ci-après et des figures annexées parmi lesquelles :

La figure 1 représente un bâti de pulvérisation cathodique pour la mise en oeuvre du procédé de fabrication selon l'invention,

les figures 2 et 3 représentent des variantes de réalisation du bâti de la figure 1,

les figures 4 et 5 sont des diagrammes explicatifs relatifs aux films minces selon l'invention,

La figure 6 est une vue en coupe d'un support d'information selon l'invention,

La figure 7 est une vue en plan d'un fragment de film ayant subi une inscription thermo-optique.

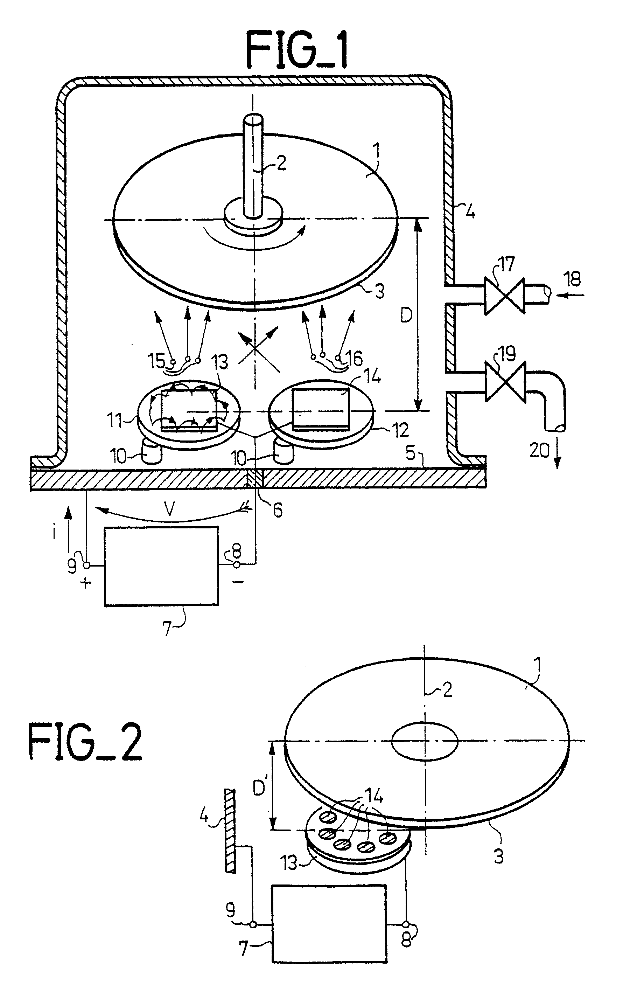

Sur la figure 1, on peut voir le substrat 1 d'un support d'information au cours de la phase de dépôt d'un film mince métallique. Le substrat 1 est par exemple un disque perméable au rayonnement inscripteur, qui doit recevoir sur sa face 3 un dépôt métallique mince pour absorber ce rayonnement et obtenir un dégagement calorifique. A cet effet, le disque 1 est monté sur un support rotatif 2 avec la surface d'accueil 3 tournée vers la base 5 d'un bâti de pulvérisation cathodique. Le bâti de pulvérisation cathodique comporte une chape 4 qui forme avec la base 5 une enceinte similaire à celle d'un bâti d'évaporation sous vide. Pour réaliser le vide dans l'enceinte, on a prévu un raccord avec un robinet 19 qui est relié par un conduit 20 à une pompe à vide. Un autre raccord est prévu avec un robinet 17 qui est relié à un conduit d'adduction de gaz. La base 5 Est munie d'une traversée électrique étanche 6 dont le conducteur isolé de la base est relié au pôle négatif 8 d'une source électrique 7. Le pôle positif 9 de la source 7 est relié à la base 5. A l'intérieur de l'enceinte 4,5 sont prévus deux porte cibles 11 et 12 situés à la distance D de la face 3 du disque 1. Chaque porte cible 11 ou 12 est porté sur des colonnettes isolantes 10 qui reposent sur la base 5.

Deux cibles en métal 13 et 14 sont respectivement déposées sur les porte cibles 11 et 12 et reliées électriquement au conducteur isolé de la traversée étanche 6. La source 7 est capable de développer une tension électrique V de quelques centaines de volt pour ioniser le gaz contenu dans l'enceinte de pulvérisation cathodique 4,5. Lorsque cette ionisation se produit, un courant i de l'ordre d'un ampère est débité par la source 7.

Le dépôt à effectuer par pulvérisation cathodique doit avoir une composition telle qu'il présente de bonnes qualités de résistance à l'oxydation. C'est pourquoi l'une des cibles 13 ou 14 est constituée par un métal précieux tel que l'or.

L'autre cible est faite d'un métal de transition qui sert d'adjuvant. Le métal adjuvant est généralement plus oxydable que le métal précieux choisi. Dans la suite de la description, la composition du dépôt métallique est faite d'or et de chrome.

Par opposition à la technique d'évaporation sous vide qui nécessite un vide très poussé et qui n'utilise pas de décharge électrique pour extraire les particules métalliques, la présente invention met en oeuvre le bombardement d'une cible pour extraire des atomes neutres des métaux à déposer, ce qui permet de réaliser un dosage basé sur la surface émettrice des cibles, procédé de dosage géométrique bien plus souple à mettre en oeuvre que celui qui consiste à évaporer les métaux à partir de creusets chauffés. La décharge électrique produite dans l'enceinte 4,5 fait suite à une opération de pompage qui a abaissé la pression dans le bâti à une valeur de l'ordre de $2,7 \times 10^{-3}$mbar ($2.10^{-6}$ Torr). Pendant cette opération préalable, le robinet 19 est ouvert et le robinet 17 est fermé. Pour rendre possible la décharge électrique avec une basse tension d'alimentation de l'ordre de 200 Volts, on ouvre le robinet 17, afin d'introduire de l'argon dans l'enceinte 4,5 et l'on règle cette adduction de gaz rare pour atteindre une pression de l'ordre de $4 \times 10^{-3}$mbar ($3.10^{-3}$ Torr). On peut ajouter au gaz rare un autre gaz tel que l'hydrogène qui possède un effet réducteur important utile pour préparer la surface d'accueil 3 à recevoir le dépôt métallique. On sait qu'avec un vide poussé, le libre parcours moyen des particules évaporées peut atteindre plusieurs mètres. Il en va autrenent lors d'une pulvérisation avec une pression réduite d'argon de $10^{-3}$mbar ($10^{-3}$ Torr), car le libre parcours moyen des particules effectuées de la cible est de l'ordre de 5 cm. Du fait des collisions plus fréquentes des particules métalliques arrachées avec les atomes gazeux présents entre les cibles 13 et 14 et le disque 1, on adopte une distance D de l'ordre de 18 à 20 cm, ce qui permet de disposer de particules dont l'énergie cinétique résiduelle permet d'assurer une grande densité de sites de nucléation. Dans le cas de l'évaporation sous vide, la distance D pourrait être beaucoup plus grande puisque la propagation a a lieu dans un milieu très raréfié, mais l'énergie à l'approche du substrat est est trop faible pour donner lieu à des impacts francs dès que des premiers sites de nucléation se sont formés. Les particules arrivantes viennent nourrir ces ces sites sans en créer de nouveaux de sorte que le dépôt se présente sous la forme d'un agrégat polycristallin à texture relativement grossière.

Pour permettre un bon rendement d'extraction et pour limiter l'étendue de la zone où sont situées les particules chargées qui servent à bombarder les cibles 13 et 14, l'invention prévoit d'équiper chaque porte porte cible 11, 12 d'aimants permanents disposés pour contraindre les électrons qui rebondissent sur la cible à retomber sur celle-ci. Ce mouvement à à trajectoire en arceaux est illustré sur la figure 1 au dessus de la cible 13. Les particules neutres arrachées 15 et 16 échappent à ce confinement par champ magnétique, mais ont assez d'énergie cinétique pour surmonter les collisions qu'elles ne manquent pas d'avoir avec le gaz de remplissage. Le confinement par champ magnétique favorise le rapprochement entre les cibles et la surface d'accueil 3 du disque sans porter celui-ci à une température exagérée. La rotation du disque 1 pendant le dépôt d'un film métallique contribue à l'homogénéité du dépôt et permet de réduire la collecte de chaleur. Un dépôt sous une épaisseur e de $150 \times 10^{-10}$m (150 Angströms) nécessite une pulvérisation d'or et de chrome pendant deux minutes, ce qui est tout à fait satisfaisant du point de vue de l'économie d'un processus de fabrication industrielle. En prévoyant un sas d'attente pour les disques, on peut atteindre un bon rendement de fabrication pour des épaisseurs déposées allant jusqu'à $200 \times 10^{-10}$m (200 Angströms) et plus. L'examen au microscope électronique, avec des grossissements très importants, montre qu'une couche déposée avec le bâti de la figure 1, pour un pourcentage de chrome de 35 % en poids, se présente comme un agrégat polycristallin ayant une taille moyenne de grain l'ordre de $70 \times 10^{-10}$m (70 Angströms). La technique de diffraction électronique permet d'apercevoir les anneaux caractéristiques de la structure cubique à faces centrées de l'or avec un faible élargissement.

Le réseau cristallin de l'or est comprimé légèrement par la présence de chrome en solution solide intersticielle.

Un agrégat polycristallin à texture superfine peut être obtenu en modifiant le bâti de la figure 1.

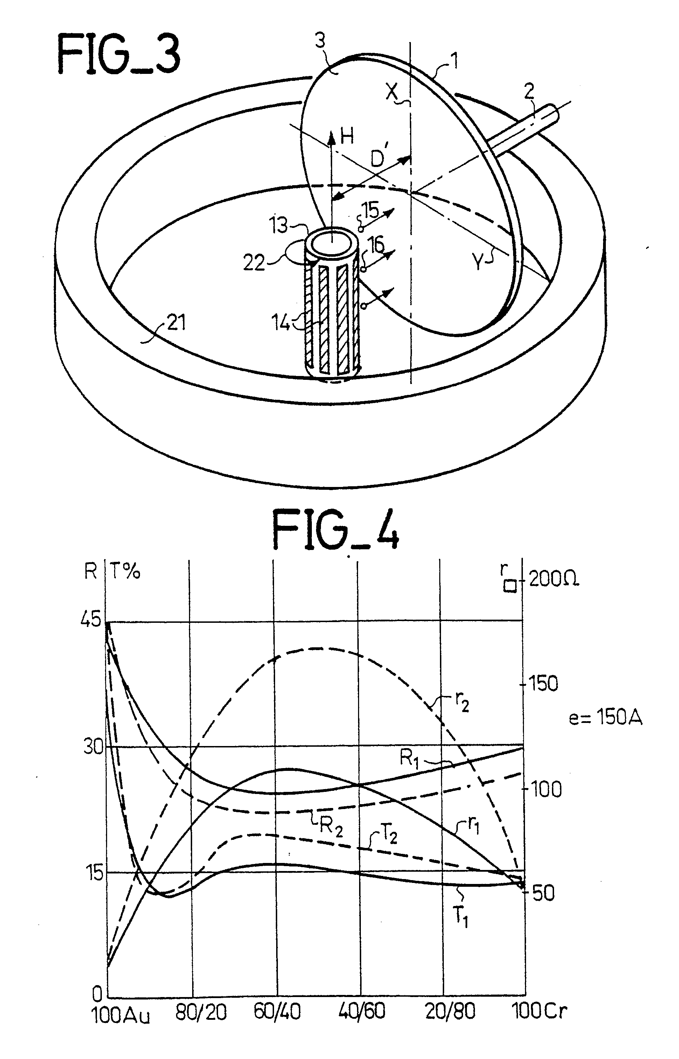

Cette variante est illustrée sur la figure 2 où l'on voit que la distance cible-disque a été réduite de moitié. On a utilisé une cible de chrome 13 dont la surface soumise au bombardement a été partiellement masquée par des pastilles d'or 14. Grâce à cette configuration plus ramassée de la cible, la distance D' a pu être ramenée à 8 cm. Même avec des grossissements de l'ordre de 300.000 à 500.000, on observe pour des concentrations en chrome de 50 % à 70 %, une texture de dépôt dont la frontière des grains reste malaisée à situer, mais qui permet néamoins de situer leur taille en deçà de 20 Angströms. Les figures de diffraction électronique présentent des anneaux diffus. Pour une composition pulvérisé à 60 % de chrome, on peut observer une texture superfine dont les grains ont une taille estimée à moins de 15 Angströms.

Une autre variante de bâti illustrée sur la figure 3 a donné des résultats de dépôt similaires à ceux obtenus avec la disposition de la figure 2. L'utilisation d'une cible 13 constituée par un cylindre de chrome portant des languettes d'or 14 permet de réaliser de confinement avec un champ magnétique H dirigé suivant l'axe de la cathode cylindrique 13,14.

Ce champ magnétique est créé à l'extérieur du bâti par un électroaimant dont on aperçoit sur la figure 3 l'enroulement 21.

La face d'accueil 3 du disque 1 est disposée parallèlement à l'axe de la cathode. La trajectoire en arceau 22 illustre le mouvement des particules chargées dans le champ H et les flèches dirigées vers le disque 1 représentent le mouvement des particules métalliques 15 et 16 d'or et de chrome. Cette disposition se prête à un dépôt avec masquage qui présente une zone radiale de dépôt produisant un film homogène par rotation du disque autour de l'axe du support 2. Avec une distance D' de l'ordre de 10 cm, on peut réaliser une couche de $150 \times 10^{-10}$ m (150 Angströms) en vingt minutes lorsqu'on prévoit un masque délimiteur entre la cathode et la face 3 du disque 1. On peut noter que la distance cible-surface d'accueil est sensiblement deux fois moindre en adoptant les dispositions des figures 2 et 3 comparée à celle adoptée dans le bâti de la figure 1. Cette différence a une incidence sur la taille des grains qui peut se justifier en partie par l'influence sur la température du substrat qui joue un rôle dans la nucléation et la croissance des films minces.

Les dépôts obtenus au moyen des bâtis de pulvérisation cathodique qui viennent d'être décrits ont été étudiés en ce qui concerne les propriétés électriques et optiques. Les dépôts étaient réalisés sur verre et les mesures de réflectivité R effectuées avec un faisceau traversant le substrat pour atteindre le dépôt. La détermination de la résistance électrique en ohm par carré est importante pour juger de la résistivité thermique des films déposés.

Les résultats de mesure pour un dépôt d'épaisseur $\epsilon = 150 \times 10^{-10}$ m (150 Angströms) sont consignés dans le diagramme de la figure 4. En abscisse on a porté la composition pondérale donnant par un premier nombre le pourcentage d'or et par un second nombre le pourcentage de chrome qui augmente de gauche à droite. Les courbes en trait plein représentent en pourcents le pouvoir réflecteur $R_1$ et le pouvoir de transmission $T_1$ pour un dépôt réalisé dans le bâti de la figure 1. La courbe référencée $r_1$ indique la résistance en ohm par carré de ce dépôt. Les mesures optiques sont effectuées à la longueur d'onde $\lambda = 632,8$ nm avec une puissance insuffisante pour engendrer un changement de caractéristique optique.

Les courbes en pointillé référencées $R_2$, $T_2$, et $r_2$ se rapportent à un dépôt de même épaisseur effectué avec le bâti illustré sur la figure 2. On n'a pas représenté de courbes correspondant à un dépôt effectué avec le bâti illustré sur la figure 3, car l'oxydation n'est pas négligeable lorsque la durée de dépôt passe de 2 à 20 minutes.

On voit sur la figure 4 qu'à droite d'une composition 90/10, soit avec plus de 10 % en poids de chrome, les courbes $R_1$ et $T_1$ et les courbes $R_2$ et $T_2$ oscillent peu et sont plutôt symétriques par rapport à une horizontale passant par l'ordonnée 20 %. Ce résultat est tout à fait remarquable, car il signifie que la fraction absorbée du rayonnement optique incident s'établit à 60 % quel que soit le pourcentage de chrome entre 10 et 100 %. Un autre résultat remarquable concerne les courbes $r_1$ et $r_2$ qui culminent au voisinage de la composition 60/40. La résistance par carré des couches pulvérisées est tout à fait reproductible, car ces couches bénéficient d'une bonne continuité et pour les application du domaine de la transcription thermo-optique de données, les courbes donnant cette résistance permettent d'escompter une très faible diffusivité thermique qui, couplée à un pouvoir absorbant élevé et constant, permet d'envisager un processus d'écriture efficace, peu sensible à la composition et bien localisé au point d'impact du faisceau inscripteur. La composition $Au_{60}Cr_{40}$ est pratiquement à son point culminant un ordre de grandeur supérieur aux alliages de composition analogue.

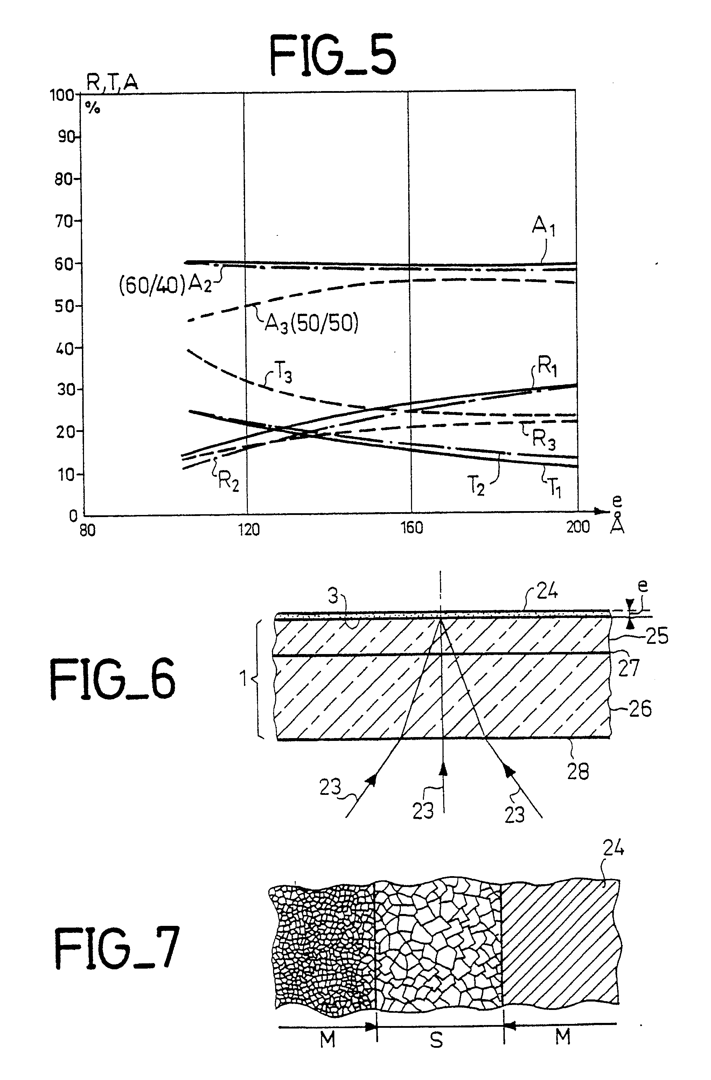

Pour compléter les résultats de la figure 4, on a tracé à la figure 5 un diagramme qui donne en fonction de l'épaisseur $\epsilon$ du dépôt le comportement des paramètres optiques R, T et A.

Le pouvoir absorbant A est donné par l'expression:

$$A = 100 - R - T$$

où R et T sont les pouvoirs réflecteurs et de transmission en pourcents.

Les indices 1 et 2 se rapportent à des dépôts de composition 60/40 effectués avec les bâtis des figures 1 et 2. L'indice 3 se rapporte à un dépôt de composition de 50/50 effectué par évaporation sous vide.

On voit que les films obtenus par pulvérisation cathodique se signalent par un pouvoir absorbant $A_1$ ou $A_2$ supérieur au pouvoir absorbant $A_3$ du dépôt évaporé. On note aussi qu'entre $100 \times 10^{-10}$ m (100 Angströms) et $200 \times 10^{-10}$ m (200 Angströms), le pouvoir absorbant des films pulvérisés est remarquablement indépendant de l'épaisseur $\epsilon$ choisie. Ceci signifie que le paramètre épaisseur n'est pas critique en ce qui concerne le rendement optothermique du film et qu'il permet notamment de choisir le pouvoir réflecteur entre 15 et 30 %, voir entre 10 et 30 % avec une couche à texture superfine.

L'explication de ces résultats surprenants semble liée à la texture des agrégats polycristallins et/ou à la teneur en oxygène, mais il parait clair que la réduction de la distance séparant la cible de la surface d'accueil (courbes en pointillé de la figure 4) améliore nettement l'efficacité et la latitude de fabrication des dépôts utilisables pour réaliser des structures thermosesibles. Lorsque le dépôt est effectué avec comme gaz de remplissage un mélange de gaz rare et d'hydrogène, on a constaté une diminution de réflectivité des dépôts. On sait par ailleurs que l'hydrogène a tendance à se loger aux joints de grains et qu'il est un réducteur chimique efficace.

La figure 6 est une vue en coupe d'une structure thermosensible utilisant une couche déposée 24 selon le procédé de pulvérisation cathodique rapprochée. On peut partir d'un substrat de verre 26, à la surface 27 duquel on dépose une sous-couche transparente 25 dont la face supérieure 3 joue le rôle de surface d'accueil de la couche 24. La face 3 peut reproduire un relief de prégravure. L'inscription de l'information peut se faire à travers le substrat 26 et la sous couche 25 avec un faisceau optique focalisé 23 qui pénètre par la face 28 du substrat. Cette structure permet l'écriture par ablation, mais on peut également produire par dégradation localisée de la sous couche 25 un décollement sans rupture de la couche métallique 3.

En soumettant des dépôts réalisés par pulvérisation cathodique à une inscription thermo-optique, on a constaté par un examen au microscope électronique un changement de texture de l'agrégat polycristallin. La figure 7 représente l'image électronique d'un minuscule fragment de couche pulvérisée 24 vu de face, avec une zone centrale S qui a subi un échauffement transitoire par irradiation avec un faisceau laser. Les zones avoisinantes M ont conservé la texture superfine qui a été détaillée à gauche sur la figure 7. Par contre, on constate que la zone centrale irradiée S présente une texture à grains beaucoup plus gros. Ce phénomène qui fait songer à un recuit, mis à part le fait qu'il est ultrarapide constitue à lui seul un mode d'écriture thermo-optique puisque les caractéristiques optiques sont modifiées par ce changement de texture. Le fait de disposer d'une plage à texture plus grossière entre deux plages à texture plus fine représente aussi une prégravure puisque la limite élastique du dépôt métallique est influencée par la taille des grains. Par réexposition, cette prégravure qui sert de guide à un faisceau optique d'écriture va permettre d'inscrire des données soit dans la plage 5, soit dans les plages M adjacentes.

L'étude de la diffraction produite par les agregats polycristallins obtenus par pulvérisation cathodique rapprochée d'une composition métallique d'or et de chrome a permis de caractériser les paramètres de maille des dépôts.

Pour des concentrations en poids de chrome inférieures à 50 % c'est le réseau de l'or que l'on observe avec en solution solide intersticielle l'atome de chrome qui produit une compression du réseau d'or. Avec des concentrations en chrome dans la plage 50 à 60 % (une concentration de 50 % en poids de chrome équivaut à une concentration atomique de 78 %), la situation tend à s'inverser et l'on observe au delà de cette plage le réseau cubique du chrome dilaté par des atomes d'or en solution solide intersticielle. Sachant que la limite de solubilité en volume des atomes de chrome dans l'or est proche de 20 %, les films minces à forte teneur en or peuvent être sursaturés en chrome jusqu'à une concentration de 40 % de chrome où ce métal de transition à faible rayon atomique joue le rôle de soluté avec compression de la maille cristalline du substrat. Les extrêmas des courbes de la figure 4 paraissent liés à l'inversion de la structure cristallographique qui passe de la structure cubique à faces centrées de l'or à la structure cubique du chrome au delà d'une concentration pondérale de chrome égale à 40 % (cette concentration pondérale équivaut à une concentration atomique de 75 %).

En outre, au delà d'une concentration de 15 % de chrome qui est proche de la limite de solubilité en volume du chrome dans l'or, l'évolution des propriétés optiques n'est pas sensible comparée à celle des propriétés électriques. Les paramètres optiques de couche semblent être beaucoup plus liés au chrome et ce dans un large domaine de composition. Les mesures de pouvoir absorbant optique et de pouvoir de transmission optique pour un domaine de longueurs d'ondes allant de 400 nm à 1200 nm confirment une tendance générale orientée vers la réponse optique du chrome, ceci étant vrai pour des teneurs pondérale en chrome de 50 % à 100 %.

Bien entendu, l'invention n'est pas limitée au cas d'un dépôt sur verre. La surface d'accueil peut appartenir à n'importe quelle matière de support inorganique ou organique et peut notamment appartenir à une sous couche qui améliore la tenue ou la continuité du dépôt.

## Revendications

1. Procédé de fabrication d'un support d'information à inscription thermo-optique du type comportant une structure thermosensible adaptée au stockage et à la lecture optique d'information, ladite structure étant munie d'une couche mince métallique (24) qui, en collectant le rayonnement inscripteur incident, produit un échauffement transitoire localisé faisant naître au-dessus d'un seuil de température un changement de caractéristique optique de ladite structure thermosensible, ledit procédé comportant à cet effet le dépôt d'un agrégat polycristallin en forme de film mince (24) recouvrant continûment une surface d'accueil (3) de ladite structure, ce dépôt provenant d'un flux incident de particules (15,16) de métal précieux et d'un métal de transition, caractérisé en ce que, pour obtenir une composition métallique déterminée, lesdites particules métalliques (15,16) sont extraites d'une cible de chrome et d'une cible (14) d'or (13), exposées au bombardement d'autres particules confinées par champ magnétique (H) qui proviennent d'une décharge électrique à tension de l'ordre de 200 volts dans de l'argon sous pression réduite de l'ordre de $10^{-3}$ torr (1 torr = 1.3hPa) et en ce que la distance (D) cible-surface d'accueil est de l'ordre de 18 à 20 cm, la surface d'accueil (3) collectant les particules métalliques (15, 16) avec une énergie résiduelle donnant lieu à une densité de sites de nucléation accrue par rapport à celle d'un dépôt similaire par évaporation sous vide.

2. Procédé de fabrication d'un support d'information à inscription thermo-optique du type comportant une structure thermosensible adaptée au stockage et à la lecture optique d'information, ladite structure étant munie d'une couche mince métallique (24) qui, en collectant le rayonnement inscripteur incident, produit un échauffement transitoire localisé faisant naître au-dessus d'un seuil de température un changement de caractéristique optique de ladite structure thermosensible, ledit procédé comportant à cet effet le dépôt d'un agrégat polycristallin en forme de film mince (24) recouvrant continument une surface d'accueil (3) de ladite structure, ce dépôt provenant d'un flux incident de particules (15,16) de métal précieux et d'un métal de transition, caractérisé en ce que, pour obtenir une composition métallique déterminée, lesdites particules métalliques (15,16) sont extraites d'une cible (13) de chrome partiellement masquée par des pastilles d'or, cette cible étant exposée au bombardement d'autres particules confinées par champ magnétique (H) qui proviennent d'une décharge électrique sous tension de l'ordre de 200 volts dans de l'argon sous pression réduite de l'ordre de $10^{-3}$ τtorr(1 torr = 1.3hPa) la distance (D') cible-surface d'accueil étant de l'ordre de 8 cm, et la surface d'accueil collectant les particules métalliques avec une énergie résiduelle donnant lieu à une densité de sites de nucléation accrue par rapport à celle d'un dépôt similaire par évaporation sous vide.

3. Procédé de fabrication d'un support d'information à inscription thermo-optique du type comportant une structure thermosensible adaptée au stockage et à la lecture optique d'information, ladite structure étant munie d'une couche mince métallique (24) qui, en collectant le rayonnement inscripteur incident, produit un échauffement transitoire localisé faisant naître au-dessus d'un seuil de température un changement de caractéristique optique de ladite structure thermosensible, ledit procédé comportant à cet effet le dépôt d'un agrégat polycristallin en forme de film mince (24) recouvrant continument une surface d'accueil (3) de ladite structure, ce dépôt provenant d'un flux incident de particules (15,16) de métal précieux et d'un métal de transition, caractérisé en ce que, pour obtenir une composition métallique déterminée, lesdites particules métalliques (15,16) sont extraites d'une cible cylindrique (13) constituée de chrome, sa surface exposée au bombardement étant partiellement recouverte par l'or, cette cible étant exposée au bombardement d'autres particules confinées par champ magnétique (H) dirigé suivant l'axe de la cible cylindrique et qui proviennent d'une décharge électrique d'une tension de l'ordre de 200 volts dans un gaz rare sous pression réduite de l'ordre de $10^{-3}$ torr (1 = 1.3hPa) la surface d'accueil, disposée parallèlement à l'axe de la cible, étant à une distance de cette dernière de l'ordre de 10 cm et collectant les particules métalliques (15, 16) avec une énergie résiduelle donnant lieu à une densité de sites de nucléation accrue par rapport à celle d'un dépôt similaire par évaporation sous vide.

4. Couche métallique pour support d'information inscriptible thermooptiquement, cette couche étant mince et destinée à collecter un rayonnement inscripteur incident qui produit un échauffement transitoire localisé faisant naître au-dessus d'un seuil de température un changement de caractéristique optique, cette couche ayant la forme d'un dépôt d'un agrégat polycristallin en forme de film mince (24) recouvrant continument une surface d'accueil (3) et étant formée d'un métal précieux et d'un métal de transition, caractérisée en ce que la teneur pondérale en chrome dépasse la limite de solubilité en volume dans de l'or.

5. Couche métallique pour support d'information inscriptible thermooptiquement, cette couche étant mince et destinée à collecter un rayonnement inscripteur incident qui produit un échauffement transitoire localisé faisant naître au-dessus d'un seuil de température un changement de caractéristique optique, cette couche ayant la forme d'un dépôt d'un agrégat polycristallin en forme de film mince (24) recouvrant continument une surface d'accueil (3) et étant formée d'un métal précieux et d'un métal de transition, caractérisée en ce que cette couche forme un agrégat polycristallin comprenant 35 % de chrome et le reste d'or dont la taille moyenne de grain est de l'ordre de $70 \times 10^{-10}$m (70 Angströms), cette couche étant telle que la diffraction électronique montre des anneaux caractéristiques de la structure cubique à face centrée de l'or à faible élargissement.

6. Couche métallique pour support d'information inscriptible thermooptiquement, cette couche étant mince et destinée à collecter un rayonnement inscripteur incident qui produit un échauffement transitoire localisé faisant naître au-dessus d'un seuil de température un changement de caractéristique optique, cette couche ayant la forme d'un dépôt d'un agrégat polycristallin en forme de film mince (24) recouvrant continûment une surface d'accueil (3) et étant formée d'un métal précieux et d'un métal de transition, caractérisée en ce que cette couche forme un agrégat polycristallin contenant environ 50 à 70 % de chrome; le reste étant de l'or, et cette couche est telle que la diffraction électronique présente des anneaux diffus , la taille moyenne des grains n'excédant pas $20 \times 10^{-10}$ m ( 20 Angströms).

7. Couche selon l'une quelconque des revendications 4 à 6, caractérisée en ce que son épaisseur globale se situe entre 100 et $300 \times 10^{-10}$ m ( 100 et 300 Angströms).

8. Couche métallique selon l'une quelconque des revendications 4 à 7, caractérisée en ce que le chrome est en solution solide dans l'or.

9. Couche métallique selon l'une quelconque des revendications 4 à 7 caractérisée en __ce que l'or est en solution solide dans le chrome.

10. Couche métallique selon l'une quelconque des revendications 4 à 9, caractérisée en ce que sa texture de grains est différenciée dans son étendue par un traitement thermique de prégravure.

**Claims**

1. A process of making a thermo-optically inscribeable information carrier of the type comprising a thermosensitive structure adapted to store and to read out an optical information, said structure comprising a thin metal layer (24) which, by collecting the incident write radiation, produces a temporary local heating which creates, above a temperature threshold, a change of optical characteristics of said thermosensitive structure, said process comprising to this end the deposition of a polycrystalline aggregation in the form of a thin film (24) which totally covers a reception surface (3) of said structure, said deposition originating from an incident flow of particles (15, 16) made of a precious metal and of a transition metal, characterized in that in order to obtain a predetermined metallic composition, said metal particles (15, 16) are extracted from a chromium target (13) and from a gold target (14) which are subjected to the bombardment by other particles confined by a magnetic field (H) and originating from an electrical discharge at a voltage of about 200 Volt in an argon atmosphere under reduced pressure of about $10^{-3}$ Torr (1 Torr = 1,3 hPa), and that the distance (D) between target and reception surface is about 18 to 20 cm, the reception surface (3) collecting the metal particles (15, 16) with a residual energy which results in an increased density of nucleation sites compared with a similar evaporation deposition under vacuum.

2. A process of making a thermo-optically inscribeable information carrier of the type comprising a thermosensitive structure adapted to store and to read out an optical information, said structure comprising a thin metal layer (24) which, by collecting the incident inscription radiation, produces a temporary local heating which creates, above a temperature threshold, a change of optical characteristics of said thermosensitive structure, said process comprising to this end the deposition of a polycrystalline aggregation in the form of a thin film (24) which totally covers a reception surface (3) of said structure, said deposition originating from an incident flow of particles (15, 16) made of a precious metal and of a transition metal, characterized in that in order to obtain a predetermined metallic composition, said metal particles (15, 16) are extracted from a chromium target (13) which is partially masked by gold pallets, this target being subjected to the bombardment by other particles confined by a magnetic field (H) and originating from an electrical discharge at a voltage of about 200 Volt in an argon atmosphere under reduced pressure of about $10^{-3}$ Torr (1 Torr = 1,3 hPa), and that the distance (D') between target and reception surface is about 8 cm, the reception surface collecting the metal particles with a residual energy which result in an increased density of nucleation sites compared with a similar evaporation deposition under vacuum.

3. A process of making a thermo-optically inscribeable information carrier of the type comprising a thermosensitive structure adapted to store and to read out an optical information, said structure comprising a thin metal layer (24) which, by collecting the incident write radiation, produces a temporary local heating which creates, above a temperature threshold, a change of optical characteristics of said thermosensitive structure, said process comprising to this end the deposition of a polycrystalline aggregation in the form of a thin film (24) which totally covers a reception surface (3) of said structure, said deposition originating from an incident flow of particles (15, 16) made of a precious metal and of a transition metal, characterized in that in order to obtain a predetermined metallic composition, said metal particles (15, 16) are extracted from a cylindrical target (13) consisting of chromium and having a surface partially covered with gold and exposed to the bombardment, this target being subjected to the bombardement by other particles confined by a magnetic field (H), which is aligned to the axis of the cylindrical target, and originating from an electrical discharge at a voltage of about 200 Volt in an rare gas atmosphere under reduced pressure of about $10^{-3}$ Torr (1 Torr = 1,3 hPa), and that the distance between target and reception surface, which is disposed parallelly to the target axis, is about 10 cm, the reception surface collecting the metal particles (15, 16) with a residual energy which result in an increased density of nucleation sites compared with a similar evaporation deposition under vacuum.

4. A metal layer for a thermo-optically inscribeable information carrier, said layer being thin and being intended to collect an incident write radiation which produces a temporary and local heating which changes above a temperature threshold the optical characteristics, this layer being constituted by a polycrystalline aggregation in the form of a thin film (24) which totally covers a reception surface (3) and which is made of a precious metal and of transition metal, characterized in that the content by weight of chromium exceeds the volume solubility limit in gold.

5. A metal layer for a thermo-optically inscribeable information carrier, said layer being thin and being intended to collect an incident write radiation which produces a temporary and local heating which changes above a temperature threshold the optical characteristics, this layer being constituted by a polycrystalline aggregation in the form of a thin film (24) which totally covers a reception surface (3) and which is made of a precious metal and of transition metal, characterized in that said layer constitutes a polycrystalline aggregation including 35 % of chromium and 65% gold, the mean grain size being about $70 \cdot 10^{-10}$ m (70 Å), this layer being such that the electronic diffraction shows characteristic rings of the cubic structure with centered surface of the gold and with slight enlargement.

6. A metal layer for a thermo-optically inscribeable information carrier, said layer being thin and being intended to collect an incident write radiation which produces a temporary and local heating which changes above a temperature threshold the optical characteristics, this layer being constituted by a polycrystalline aggregation in the form of a thin film (24) which totally covers a reception surface (3) and which is made of a precious metal and of transition metal, characterized in that this layer constitutes a polycrystalline aggregation containing about 50 to 70% of chromium, the rest being gold, and this layer is such that the electronic diffraction presents diffused rings and the mean grain size does not exceed $20 \cdot 10^{-10}$ - (20 Å).

7. A layer according to any one of claims 4 to 6, characterized in that its overall thickness is about between 100 and $300 \cdot 10^{-10}$ m (100 and 300 Å).

8. A metal layer according to any one of claims 4 to 7, characterized in that the chromium is in a solid solution in the gold.

9. A metal layer according to any one of claims 4 to 7, characterized in that gold is in a solid solution in the chromium.

10. A metal layer according to any one of claims 4 to 9, characterized in that its grain texture is differentiated by a thermo-pre-engraving treatment in its extent.

## Ansprüche

1. Verfahren zur Herstellung eines thermooptisch beschreibbaren Informationsträgers, der eine temperaturempfindliche Struktur besitzt, die zur Speicherung von optisch auslesbaren Informationen geeignet ist und die eine dünne Metallbeschichtung (24) aufweist, die bei Bestrahlung mit einem Schreibstrahl eine vorübergehende örtliche Erwärmung erzeugt, derart, daß oberhalb einer Temperaturschwelle sich eine Änderung der optischen Kennwerte der temperaturempfindlichen Struktur ergibt, wobei hierzu im Rahmen des Verfahrens ein polykristallines Aggregat in Form eines dünnen Films (24) abgeschieden wird, der die ganze Unterlagefläche (3) der Struktur bedeckt und von einem einfallenden Partikelfluß (15, 16) aus Edelmetall und einem Übergangsmetall gebildet wird, dadurch gekennzeichnet, daß die Metallpartikel (15, 16) zum Erhalt einer bestimmten metallischen Zusammensetzung von einem Chromtarget (13) und einem Goldtarget (14) geliefert werden, die einem Beschuß durch andere von einem Magnetfeld (H) eingeschlossene Partikel ausgesetzt sind, wobei diese Partikel von einer elektrischen Entladung mit einer Spannung von etwa 200 Volt in Argon unter verringertem Druck einer Größenordnung von $10^{-3}$ Torr stammen (1 Torr = 1,3 hPa), und daß der Abstand (D) zwischen Target und der Unterlagefläche zwischen etwa 18 und 20 cm beträgt, wobei die Unterlagefläche (3) die Metallpartikel (15, 16) mit einer Restenergie aufnimmt, die zu einer erhöhten Dichte von Kernbildungsstellen im Vergleich zu einem ähnlichen Aufdampfungsverfahren im Vakuum führt.

2. Verfahren zur Herstellung eines thermooptisch beschreibbaren Informationsträgers, der eine temperaturempfindliche Struktur besitzt, die zur Speicherung von optisch auslesbaren Informationen geeignet ist und die eine dünne Metallbeschichtung (24) aufweist, die bei Bestrahlung mit einem Schreibstrahl eine vorübergehende örtliche Erwärmung erzeugt, derart, daß oberhalb einer Temperaturschwelle sich eine Änderung der optischen Kennwerte der temperaturempfindlichen Struktur ergibt, wobei hierzu im Rahmen des Verfahrens ein polykristallines Aggregat in Form eines dünnen Films (24) abgeschieden wird, der die ganze Unterlagefläche (3) der Struktur bedeckt und von einem einfallenden Partikelfluß (15, 16) aus Edelmetall und einem Übergangsmetall gebildet wird, dadurch gekennzeichnet, daß die Metallpartikel (15, 16) zum Erhalt einer bestimmten metallischen Zusammensetzung von einem Chromtarget (13) geliefert werden, das teilweise mit Goldplättchen maskiert ist und einem Beschuß durch andere von einem Magnetfeld (H) eingeschlossene Partikel ausgesetzt ist, wobei diese Partikel von einer elektrischen Entladung mit einer Spannung von etwa 200 Volt in Argon unter verringertem Druck einer Größenordnung von $10^{-3}$ Torr stammen (1 Torr = 1,3 hPa), und daß der Abstand (D') zwischen Target und der Unterlagefläche etwa 8 cm beträgt, wobei die Unterlagefläche die Metallpartikel mit einer Restenergie aufnimmt, die zu einer erhöhten Dichte von Kernbildungsstellen im Vergleich zu einem ähnlichen Aufdampfungsverfahren im Vakuum führt.

3. Verfahren zur Herstellung eines thermooptisch beschreibbaren Informationsträgers, der eine temperaturempfindliche Struktur besitzt, die zur Speicherung von optisch auslesbaren Informationen geeignet ist und die eine dünne Metallbeschichtung (24) aufweist, die bei Bestrahlung mit einem Schreibstrahl eine vorübergehende örtliche Erwärmung erzeugt, derart, daß oberhalb einer Temperaturschwelle sich eine Änderung der optischen Kennwerte der temperaturempfindlichen Struktur ergibt, wobei hierzu im Rahmen des Verfahrens ein polykristallines Aggregat in Form eines dünnen Films (24) abgeschieden wird, der die ganze Unterlagefläche (3) der Struktur bedeckt und von einem einfallenden Partikelfluß (15, 16) aus Edelmetall und einem Übergangsmetall gebildet wird, dadurch gekennzeichnet, daß die Metallpartikel (15, 16) zum Erhalt einer bestimmten metallischen Zusammensetzung von einem zylindrischen Target (13) geliefert werden, das aus Chrom besteht und dessen dem Beschuß ausgesetzte Fläche teilweise mit Gold bedeckt ist, wobei dieses Target einem Beschuß durch andere von einem Magnetfeld (H) eingeschlossene Partikel ausgesetzt ist, das gemäß der Achse des zylindrischen Targets ausgerichtet ist, wobei diese Partikel von einer elektrischen Entladung mit einer Spannung von etwa 200 Volt in einem Edelgas unter verringertem Druck einer Größenordnung von $10^{-3}$ Torr stammen (1 Torr = 1,3 hPa), und daß der Abstand zwischen Target und der Unterlagefläche etwa 10 cm beträgt, wobei die Unterlagefläche die Metallpartikel (15, 16) mit einer Restenergie aufnimmt, die zu einer erhöhten Dichte von Kernbildungsstellen im Vergleich zu einem ähnlichen Aufdampfungsverfahren im Vakuum führt.

4. Metallische Beschichtung für einen thermooptisch beschreibbaren Informationsträger, wobei die Beschichtung dünn und dazu bestimmt ist, die Strahlung eines Schreibstrahls aufzufangen, der eine vorübergehende örtliche Erwärmung erzeugt, die oberhalb einer Temperaturschwelle eine Änderung der optischen Kennwerte bewirkt, wobei die Beschichtung die Form eines Niederschlags eines polykristallinen Aggregats als dünner Film (24) besitzt, der eine Unterlagefläche (3) vollständig bedeckt und von einem Edelmetall und einem Übergangsmetall gebildet wird, dadurch gekennzeichnet, daß der Gewichtsanteil des Chroms die volumenmäßige Lösbarkeitsgrenze in Gold überschreitet.

5. Metallische Beschichtung für einen thermooptisch beschreibbaren Informationsträger, wobei die Beschichtung dünn und dazu bestimmt ist, die Strahlung eines Schreibstrahls aufzufangen, der eine vorübergehende örtliche Erwärmung erzeugt, die oberhalb einer Temperaturschwelle eine Änderung der optischen Kennwerte bewirkt, wobei die Beschichtung die Form eines Niederschlags eines polykristallinen Aggregats als dünner Film (24) besitzt, der eine Unterlagefläche (3) vollständig bedeckt und von einem Edelmetall und einem Ubergangsmetall gebildet wird, dadurch gekennzeichnet, daß diese Beschichtung ein polykristallines Aggregat bildet, das 35% Chrom und im übrigen Gold enthält, wobei die mittlere Korngröße in der Größenordnung von 70 . $10^{-10}$ m (70 Å) liegt und diese Beschichtung so gebildet ist, daß die elektronische Brechung charakteristische Ringe der kubischen Struktur bei zentrierter Seite des Goldes mit geringer Vergrößerung zeigt.

6. Metallische Beschichtung für einen thermooptisch-beschreibbaren Informationsträger, wobei die Beschichtung dünn und dazu bestimmt ist, die Strahlung eines Schreibstrahls aufzufangen, der eine vorübergehende örtliche Erwärmung erzeugt, die oberhalb einer Temperaturschwelle eine Änderung der optischen Kennwerte bewirkt, wobei die Beschichtung die Form eines Niederschlags eines polykristallinen Aggregats als dünner Film (24) besitzt, der eine Unterlagefläche (3) vollständig bedeckt und von einem Edelmetall und einem Übergangsmetall gebildet wird, dadurch gekennzeichnet, daß diese Beschichtung ein polykristallines Aggregat bildet, das etwa 50 bis 70% Chrom und im übrigen Gold enthält, wobei diese Beschichtung so ausgebildet ist, daß die elektronische Brechung diffuse Ringe zeigt, und die mittlere Korngröße nicht 20 . $10^{-10}$ (20 Å) überschreitet.

7. Beschichtung nach einem beliebigen der Ansprüche 4 bis 6, dadurch gekennzeichnet, daß die Gesamtdicke zwischen etwa 100 und 300 . $10^{-10}$ m (100 und 300 Å) liegt.

8. Metallbeschichtung nach einem beliebigen der Ansprüche 4 bis 7, dadurch gekennzeichnet, daß sich das Chrom in einer festen Lösung im Gold befindet.

9. Metallbeschichtung nach einem beliebigen der Ansprüche 4 bis 7, dadurch gekennzeichnet, daß sich das Gold in einer festen Lösung im Chrom befindet.

10. Metallbeschichtung nach einem beliebigen der Ansprüche 4 bis 9, dadurch gekennzeichnet, daß die Korntextur in ihrer Ausbreitung durch eine thermische Vorgravurbehandlung differenziert ist.

# FIG_1

# FIG_2

# FIG_3

# FIG_4

# FIG_5

# FIG_6

# FIG_7